## Europäisches Patentamt

## European Patent Office

## Office européen des brevets

(11) Veröffentlichungsnummer: **0 005 256**
**A2**

# EUROPÄISCHE PATENTANMELDUNG

(21) Anmeldenummer: 79101313.9

(22) Anmeldetag: 02.05.79

(51) Int. Cl.²: **H 03 J 1/18, H 04 B 1/40**

(30) Priorität: 03.05.78 DE 2819386

(71) Anmelder: **ROBERT BOSCH GMBH, Postfach 50, D-7000 Stuttgart 1 (DE)**

(43) Veröffentlichungstag der Anmeldung: 14.11.79 Patentblatt 79/23

(72) Erfinder: **Müller, Horst, Löwensteinring 44, D-1000 Berlin 47 (DE)**
Erfinder: **Vorwerk, Helmut, Dipl.-Ing., Luise-Henriette-Strasse 3, D-1000 Berlin 42 (DE)**

(74) Vertreter: **Schmidt, Hans-Ekhardt, Robert Bosch GmbH Geschäftsbereich Elektronik Patent- und Lizenzabteilung Forckenbeckstrasse 9-13, D-1000 Berlin 33 (DE)**

(84) Benannte Vertragsstaaten: **AT DE FR IT NL**

(54) Fernbedienung für Funksprechgeräte.

(57) Die Erfindung betrifft eine Fernbedienung für Funksprechgeräte aus einem Bedienungsteil mit Bedienungstasten, mit einer Kanalanzeige-, einer Funktionsanzeige- und einer Lautsprecher-Mikrofon-Einrichtung, wobei im Bedienungsteil ein Ultraschall- oder Infrarotsender für die Übertragung der erforderlichen Funktionssignale zum Betrieb eines Funksprechgerätes untergebracht ist, während in einem Empfangsteil am Funksprechgerät ein Ultraschall- oder Infrarotempfänger für ein Ansteuern von Funktions- und Anzeigeneinrichtungen angeordnet ist.

## Stand der Technik

Die Erfindung bezieht sich auf eine Fernbedienung nach der Gattung des Hauptanspruchs.

Es ist bereits ein Bedienungsteil mit einer Fernbedienung bekannt (z. B. Service-Unterlagen KF 80/160/450 BOSCH 1968), bei dem die Verbindung zum Funksprechgerät, das sich meistens im Kofferraum eines Fahrzeugs befindet, über ein vieladriges, langes Kabel hergestellt wird, das sich nicht leicht verlegen läßt und daher hohe Einbaukosten verursacht.

Darüber hinaus sind aus der Unterhaltungselektronik Ultraschall-/ Infrarotgeber bekannt, mit denen Geräte der Unterhaltungselektronik gesteuert werden können, und zwar nur in der Richtung vom Geber zum Gerät, ohne daß Rückmeldungen vom Gerät zum Geber möglich sind.

## Vorteile der Erfindung

Die erfindungsgemäße Fernbedienung mit den kennzeichnenden Merkmalen des Hauptanspruchs hat den Vorteil, daß statt des bisher notwendigen vieladrigen Kabels, ungefähr 26 Adern, für die Verbindung zum Funksprechgerät lediglich ein zweiadriges oder ein vieradriges Kabel benötigt wird, wobei eine eigene Spannungssquelle im Geber für ein zweiadriges Kabel erforderlich ist. Als besonderer Vorteil ist anzusehen, daß die erfindungsgemäße Fernbedienung mit den kennzeichnenden Merkmalen des Nebenanspruchs auch völlig drahtlos arbeitet, so daß überhaupt kein Kabel zwischen dem Funksprechgerät und dem Geber geschaltet ist.

Durch die in den Unteransprüchen aufgeführten Maßnahmen ist eine vorteilhafte Weiterbildung der im Hauptanspruch und im Nebenanspruch angegebenen Fernbedienung sichergestellt. Besonders vorteilhaft ist, daß bei der Ausführung gemäß den kennzeichnenden Merkmalen des Nebenanspruchs auch die Einschaltung einer Eindrahtleitung zwischen Funksprechgerät und Geber möglich ist, um einen sicheren Funkverkehr zu gewährleisten.

## Zeichnung

Ein Ausführungsbeispiel der Erfindung ist an Hand der Zeichnung näher erläutert. Es zeigen

Fig. 1   ein Blockschaltbild mit einem Verbindungskabel zwischen dem Geber und dem Empfangsteil am Funksprechgerät;

Fig. 2   Blockdiagramme vom Geber und vom Empfangsteil mit den jeweiligen Funktions- und Anzeigeneinrichtungen und

Fig. 3   ein Blockschaltbild in Flußdiagrammform vom Geber und vom Empfangsteil.

## Beschreibung der Erfindung

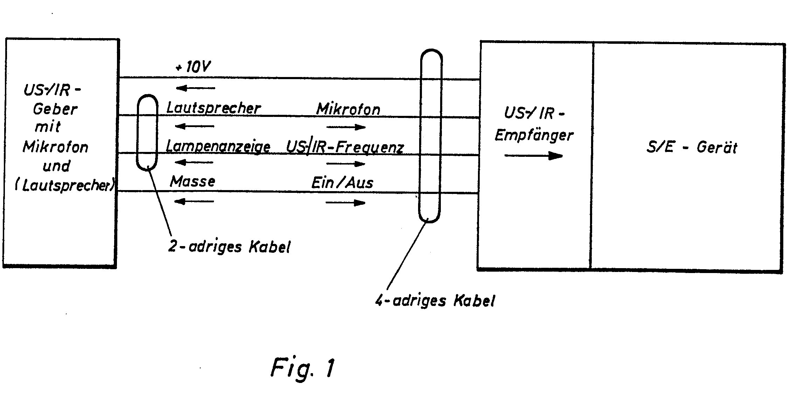

In Fig. 1 ist ein Blockschaltbild mit einem mehradrigen Verbindungskabel zwischen dem erfindungsgemäßen Geber und dem Empfangsteil am Funksprechgerät gezeigt. Dabei kann das Verbindungskabel, wenn im Geber keine eigene Spannungsquelle angeordnet ist, vieradrig oder zweiadrig ausgelegt sein, wenn im Geber eine eigene Spannungsquelle vorhanden ist. Über das zweiadrige Verbindungskabel werden dann nur noch die NF-Informationssignale für den
Lautsprecher und vom Mikrofon und die Ultraschall-/Infrarotsignale
für die Funktions- und Anzeigeneinrichtungen übertragen.

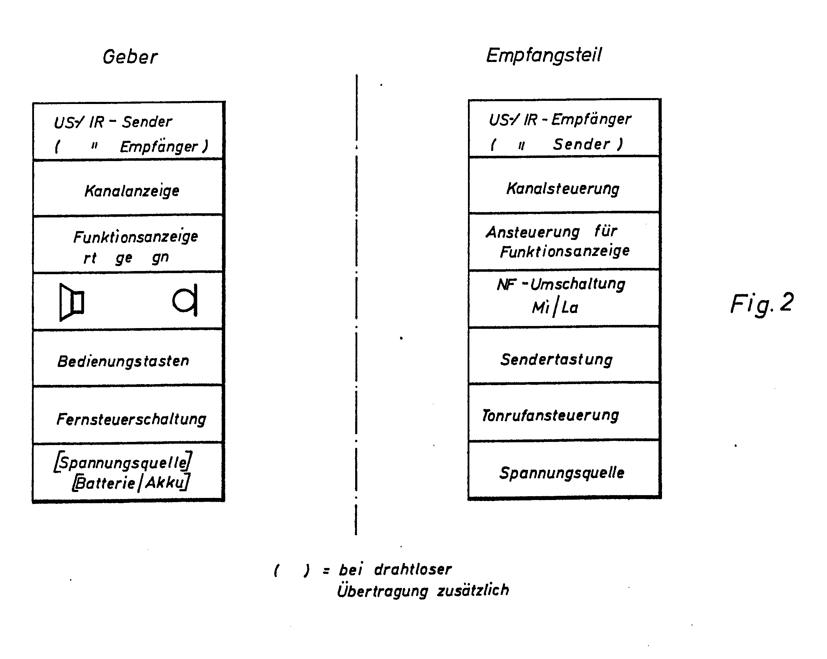

Fig. 2 zeigt Blockdiagramme jeweils vom Geber und vom Empfangsteil
mit den jeweiligen Funktions- und Anzeigeneinrichtungen, die im
Geber oder im Empfangsteil angeordnet sind. Der Geber besteht im
wesentlichen aus einem Ultraschall- oder Infrarotsender mit einer
Fernsteuerschaltung, wie zum Beispiel einem integrierten Schaltkreis vom Typ SAA 1024 oder 1050. Des weiteren ist eine Kanalanzeige vorhanden, die den eingestellten Kanal durch eine beleuchtete Markierung anzeigt. Über eine Funktionsanzeige wird signalisiert, ob ein anderer Teilnehmer auf dem eingestellten Kanal ein
Funkgespräch führt oder ob der Sender in Betrieb ist oder ob der
Teilnehmer gerufen wird. Weiter ist eine Lautsprecher-Mikrofon-
Einheit für den Austausch von Informationen vorhanden. Über im
Geber angeordnete Bedienungstasten lassen sich die einzelnen
Funktionssignale auslösen. Darüber hinaus kann im Geber eine
eigene Spannungsquelle angeordnet sein, wenn eine Übertragung
zwischen dem Geber und dem Empfangsteil am Funkgerät über eine
Zweidrahtleitung erfolgen soll.

Bei drahtloser Übertragung zwischen Geber und Empfangsteil am
Funkgerät ist darüber hinaus noch ein Ultraschall- oder Infrarotempfänger, zum Beispiel ein integrierter Schaltkreis vom Typ
SAA 1025 oder 1051, im Geber notwendig.

Das Empfangsteil ist im wesentlichen aus einem Ultraschall-
oder Infrarotempfänger, zum Beispiel einem integrierten Schaltkreis vom Typ SAA 1025 oder 1051, für die Kanalansteuerung, für
die Ansteuerung der Funktionsanzeige, für die NF-Umschaltung
des Mikrofons und des Lautsprechers, für die Sendertastung, die
Tonrufansteuerung und die Rauschsperre aufgebaut. Als Spannungsquelle dient die Stromversorgung des Funkgerätes.

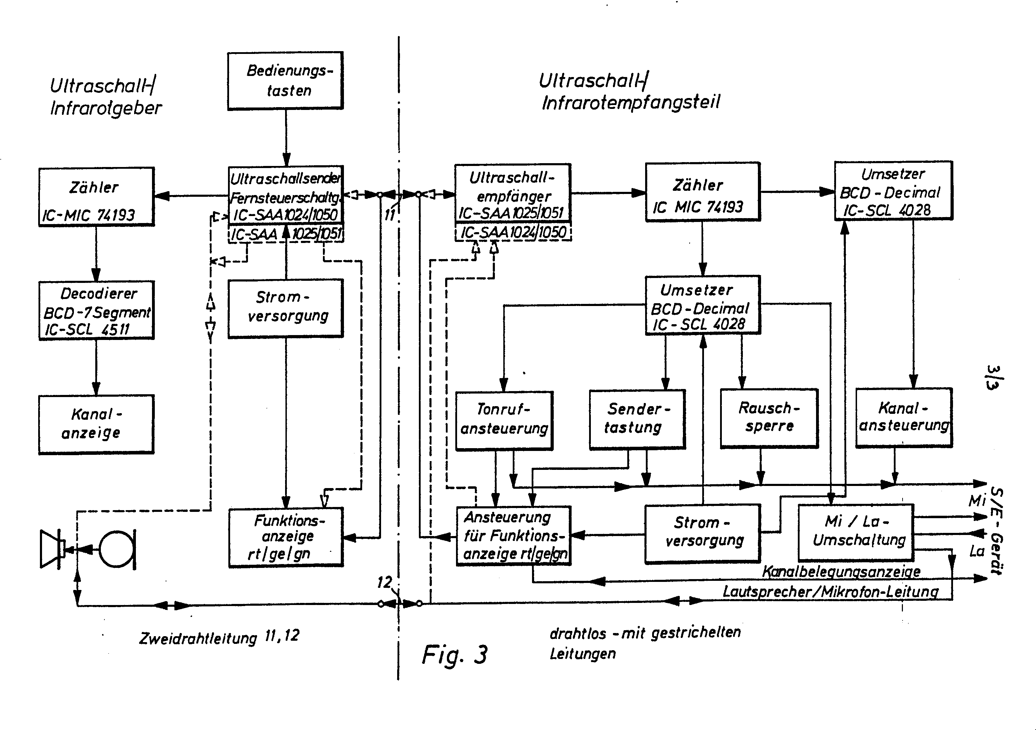

In Fig. 3 ist ein Blockschaltbild in Flußdiagrammform vom Geber
und vom Empfangsteil in der Zusammenschaltung über eine Zweidrahtleitung oder eine drahtlose Verbindung gezeigt. In der
Betriebsfunktion werden über Bedienungstasten im Ultraschall-/
Infrarotgeber die Bedienungsfunktionen eingegeben, so daß ein
Ultraschall-/Infrarotsender, zum Beispiel ein IC-SAA 1024/1050,
der von einer eigenen Spannungsquelle im Ultraschall-/Infrarotgeber versorgt wird, den Betrieb aufnimmt und die verschlüsselten
Bedienungsfunktionen als Ultraschall-/Infrarotsignale über eine
Leitung 11 aussendet. An die Leitung 11 ist ebenfalls eine Einrichtung für eine mit der Spannungsquelle verbundene Funktionsanzeige angeschlossen. Eine weitere Leitung ist von den Bedienungstasten über den Ultraschall-/Infrarotsender unmittelbar zu einem
Zähler, zum Beispiel einen IC-MIC 74193, durchgeschaltet, der die
gewählte Kanalbelegung speichert und über einen Decodierer, zum
Beispiel einen BCD-7-Segment-Decodierer vom Typ IC-SCL 4511, eine
Kanalanzeige einschaltet.

Im Ultraschall-/Infrarotempfangsteil empfängt ein Ultraschall-/
Infrarotempfänger, zum Beispiel ein IC-SAA 1025/1051, die auf der Leitung 11 übertragenen Ultraschall-/Infrarotsignale, die in BCD-Signale umgewandelt werden. Die BCD-Signale werden an einen Zähler, zum Beispiel einen IC-MIC 74193, geliefert. Der Zähler speichert die für die Kanalwahl gelieferten Signale, die über einen ersten Umsetzer, zum Beispiel einen BCD-Decimal-Umsetzer vom Typ IC-SCL 4028, an eine Einrichtung für eine Kanalansteuerung gelangen. Darüber hinaus liefert der Zähler die für andere Funktionen bestimmten Signale über einen zweiten Umsetzer des gleichen Typs an Einrichtungen für eine Tonrufansteuerung, eine Sendertastung und eine Rauschsperre, die alle über eine gemeinsame Leitung, die auch mit der Einrichtung für die Kanalansteuerung verbunden ist, am Sende-/Empfangsgerät oder Funksprechgerät angeschlossen sind. An dem zweiten Umsetzer ist ebenfalls eine Einrichtung zur Mikrofon-/Lautsprecher-Umschaltung angeschlossen. Von den Einrichtungen für die Tonrufansteuerung und die Sendertastung ist jeweils eine Leitung an eine Einrichtung für eine Ansteuerung der Funktionsanzeige geschaltet, die ebenfalls mit einer Leitung für die Kanalbelegungsanzeige vom Sende-/Empfangsgerät und mit der Leitung 11 verbunden ist. Die Umsetzer und die anderen aktiven elektronischen Bauteile, wie zum Beispiel die Einrichtung für die Ansteuerung der Funktionsanzeige, sind zur Stromversorgung an die Spannungsquelle des Funksprechgerätes angeschlossen. Über eine Lautsprecher-Mikrofon-Leitung 12 zwischen der Einrichtung zur Mikrofon-/Lautsprecher-Umschaltung und dem Ultraschall-/Infrarotgeber wird die NF-Leistung übertragen.

bei drahtlosem Funkbetrieb entfallen die Leitungen 11 und 12,
so daß Sende-/Empfangsantennen jeweils die Übertragung der
Ultraschall-/Infrarotsignale des Ultraschall-/Infrarotgebers
und des Ultraschall-/Infrarotempfängers übernehmen. Dazu ist
weiterhin erforderlich, daß für den drahtlosen Funkbetrieb
beim Ultraschall-/Infrarotgeber ein Ultraschall-/Infrarotempfänger, zum Beispiel vom Typ IC-SAA 1025/1051, und beim
Ultraschall-/Infrarotempfangsteil ein Ultraschall-/Infrarotsender, zum Beispiel vom Typ IC-SAA 1024/1050, angeordnet ist.
Die zu übertragenden oder übertragenen Signale werden dann über
die gestrichelten Leitungen geführt und nicht mehr über die
Leitungen 11 und 12.

Für einen sicheren Funkbetrieb können an Stelle der drahtlosen
Übertragung auch alle Signale über eine gemeinsame Leitung
geschickt werden, so daß jede Gefahr einer Unterbrechung des
Funkbetriebs durch zwischen dem Geber und dem Empfangsteil am
Funksprechgerät vorhandene Hindernisse ausgeschlossen ist.

_1_

ROBERT BOSCH GMBH, Stuttgart

Ansprüche

1. Fernbedienung für Funksprechgeräte aus einem Bedienungsteil
   mit Bedienungstasten, mit Kanalanzeige-, Funktionsanzeige-
   und Lautsprecher-Mikrofon-Einrichtung, dadurch gekennzeichnet,
   daß im Bedienungsteil ein Geber mit einem Ultraschall- oder
   Infrarotsender einschließlich einer Fernsteuerschaltung für
   die Übertragung der erforderlichen Funktionssignale zum
   Betrieb eines Funksprechgerätes untergebracht ist und daß ein
   Empfangsteil mit einem Ultraschall- oder Infrarotempfänger
   für ein Ansteuern von Funktions- und Anzeigeneinrichtungen
   am Funksprechgerät angebracht ist.

2. Fernbedienung nach Anspruch 1, dadurch gekennzeichnet, daß
   eine Vierdrahtleitung zwischen dem Bedienungsteil und dem
   Empfangsteil geschaltet ist.

3. Fernbedienung nach Anspruch 1, dadurch gekennzeichnet, daß
   im Bedienungsteil eine Spannungsquelle untergebracht ist und
   daß zwischen dem Bedienungsteil und dem Empfangsteil eine
   Zweidrahtleitung geschaltet ist.

4. Fernbedienung für Funksprechgeräte aus einem Bedienungsteil
   mit Bedienungstasten, mit Kanalanzeige-, Funktionsanzeige-
   und Lautsprecher-Mikrofon-Einrichtung, dadurch gekennzeichnet,
   daß im Bedienungsteil ein Geber mit einem Ultraschall- oder

Infrarotsender/-empfänger einschließlich einer Fernsteuerschaltung für die Übertragung der erforderlichen Funktionssignale sowie von NF-Informationssignalen und für den
Empfang der Funktionsanzeigesignale und NF-Informationssignale des Funksprechgerätes untergebracht ist, daß ein
Empfangsteil mit einem Ultraschall- oder Infrarotempfänger/
-sender für ein Ansteuern von Funktions- und Anzeigeneinrichtungen und ein Übertragen der empfangenen NF-Informationssignale am Funksprechgerät angebracht ist und daß im
Bedienungsteil eine Spannungsquelle eingeschlossen ist.

5. Fernbedienung nach Anspruch 4, dadurch gekennzeichnet, daß
   zwischen dem Bedienungsteil und dem Empfangsteil eine
   Eindrahtleitung geschaltet ist.

6. Fernbedienung nach einem oder mehreren der Ansprüche 1 bis 5,
   dadurch gekennzeichnet, daß das Bedienungsteil als steckbare
   Ausführung ausgelegt ist.

7. Fernbedienung nach einem oder mehreren der Ansprüche 1 bis 6,
   dadurch gekennzeichnet, daß das Bedienungsteil mit einem
   Zusatzverstärker für die NF-Spannung beschaltet ist.

8. Fernbedienung nach einem oder mehreren der Ansprüche 1 bis 7,
   dadurch gekennzeichnet, daß im Bedienungsteil als Spannungsquelle eine Batterie oder ein im Kraftfahrzeug wiederaufladbarer Akkumulator eingeschlossen ist.

8/78        - 3 -

9. Fernbedienung nach einem oder mehreren der Ansprüche 1 bis 8, dadurch gekennzeichnet, daß das Empfangsteil als Funktionseinrichtungen eine Kanalansteuerung, eine Tonrufansteuerung, eine Sendertastung, eine NF-Umschaltung und eine Rauschsperre und als Anzeigeneinrichtungen Ansteuerungen für Funktionsanzeigen aufweist.

US-/IR - Geber mit Mikrofon und (Lautsprecher)

+ 10V

Lautsprecher    Mikrofon

Lampenanzeige    US-/IR-Frequenz

Masse    Ein/Aus

2-adriges Kabel

4-adriges Kabel

US-/IR - Empfänger

S/E - Gerät

Fig. 1

Geber

Empfangsteil

| Geber |
|---|
| US-/IR – Sender<br>(  "   Empfänger ) |
| Kanalanzeige |
| Funktionsanzeige<br>rt    ge    gn |
| |
| Bedienungstasten |
| Fernsteuerschaltung |
| [Spannungsquelle]<br>[Batterie / Akku] |

| Empfangsteil |
|---|
| US-/IR – Empfänger<br>(  "   Sender ) |
| Kanalsteuerung |
| Ansteuerung  für<br>Funktionsanzeige |
| NF –Umschaltung<br>Mi / La |
| Sendertastung |
| Tonrufansteuerung |
| Spannungsquelle |

*Fig. 2*

2/3

( ) = bei drahtloser
Übertragung zusätzlich

0005256

**Ultraschall-/Infrarotgeber**

**Ultraschall-/Infrarotempfangsteil**

Fig. 3

Zweidrahtleitung 11,12

drahtlos - mit gestrichelten Leitungen

3/3

0005256